(19) Europäisches Patentamt
European Patent Office
Office européen des brevets

(11) **EP 4 761 014 A2**

(12) **EUROPEAN PATENT APPLICATION**

(43) Date of publication:
**17.06.2026 Bulletin 2026/25**

(21) Application number: **25212199.1**

(22) Date of filing: **30.10.2025**

(51) International Patent Classification (IPC):
*H01S 5/06* (2006.01)      *H01S 5/042* (2006.01)
*H01S 5/068* (2006.01)      *H01S 5/062* (2006.01)
*H01S 5/0683* (2006.01)

(52) Cooperative Patent Classification (CPC):
**H01S 5/0428; H01S 5/0617; H01S 5/06216; H01S 5/06835**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **11.12.2024 CN 202411821248**

(71) Applicants:
• **Suzhou Menovex Photonics Technology Co., Ltd Suzhou, Jiangsu 215600 (CN)**
• **Menovex Medical Technology (Shenzhen) Co., Ltd Shenzhen, Guangdong 518000 (CN)**
• **Menovex Medical Innovation (Shenzhen), LLC Shenzhen, Guangdong 518000 (CN)**

(72) Inventors:
• **HUANG, Zuyong Shenzhen, 518000 (CN)**
• **DAI, Yixiang Suzhou, 215600 (CN)**
• **JI, Encai Shenzhen, 518000 (CN)**
• **ZENG, Ke Shenzhen, 518000 (CN)**
• **HUANG, Jianwei Shenzhen, 518000 (CN)**
• **HUANG, Yujun Shenzhen, 518000 (CN)**
• **LIN, Jiayu Shenzhen, 518000 (CN)**
• **LI, Liuzhu Suzhou, 215600 (CN)**

(74) Representative: **Huang, Liwei Cäcilienstraße 12 40597 Düsseldorf (DE)**

(54) **LASER POWER CORRECTION METHOD FOR SUPPRESSING RELAXATION OSCILLATION, DEVICE AND LASER**

(57)    The present disclosure provides a laser power correction method, device, and laser for suppressing relaxation oscillation. The method includes: setting the laser to a first duty cycle and a first frequency, adjusting current so that the average power is a preset power, and recording the present current value; adjusting the frequency so that the average power is the preset power, recording all frequency values to obtain a frequency interval; changing the duty cycle to obtain frequency intervals at various duty cycles; setting the laser to a second duty cycle and the representative frequency, adjusting the current so that the average power is the minimum/maximum average power, recording the minimum and maximum currents, and determining a current-average power relationship; changing the duty cycle to obtain the current-average power relationship at various duty cycles and in different frequency intervals. The present disclosure is applicable to a pulsed laser control method that adds a small step signal to suppress relaxation oscillation. The current-average power relationship is determined by actually measuring the power output value, thereby achieving accurate correction of the laser.

FIG. 2

EP 4 761 014 A2

**Description**

<u>TECHNICAL FIELD</u>

The present disclosure relates to the field of laser power correction, and in particular to a laser power correction method for suppressing relaxation oscillation, a device and a laser.

<u>BACKGROUND</u>

In pulsed lasers, the laser power is calculated as follows: $P_a = P_p * \frac{t}{f}$, where $P_a$ is the average power, $P_p$ is the peak power, t is the peak pulse duration, and f is the pulse output frequency. To change the average laser power, you can modify at least one of these three parameters: $P_p$, t, or f.

However, after leaving the factory, lasers naturally age and they are affected by time and environment. When the laser is actually used, its curve relationship between current and peak power may deviate from that in the specification provided in the factory datasheet. Therefore, power calibration is necessary to determine the actual relationship between current and peak power. Existing power calibration/correction methods recalibrate the drive current when the average power output of the laser is deemed inaccurate.

Taking a fiber laser as an example, relaxation oscillation occurs when the gain fiber generates laser light. If it is not suppressed, there is a high probability of damage to the optical components in the laser light path. Therefore, it is necessary to suppress the peak power of the relaxation oscillation light within an acceptable range. For example, the relaxation oscillation can be suppressed by adding a small step signal to the square-wave driving current to suppress the relaxation oscillation.

The existing correction method performs correction calculations based on a square-wave driving current. After a small step signal for suppressing relaxation oscillation is added, the laser energy corresponding to the small step is increased thereto. According to the existing correction method, the average output power of laser will be inaccurate.

<u>SUMMARY</u>

In order to solve the above problems, the present disclosure provides a laser power correction method for suppressing relaxation oscillation, comprising:

Step 1: setting a duty cycle of a laser to be a first duty cycle and setting a frequency of the laser to be a first frequency, adjusting current so that an average output power of the laser is a preset power, and recording the present current value, wherein a waveform of the current comprises a first level and a second level, the amplitude of the first level is smaller than the amplitude of the second level, and the amplitude of a laser relaxation oscillation waveform induced by a current signal of first level is smaller than a safety threshold;
Step 2: adjusting the frequency based on the present current value and the first duty cycle so that the average output power of the laser is the preset power, and recording all frequency values to obtain a frequency interval;
changing the duty cycle, repeating Steps 1 and 2, to obtain frequency intervals of the laser at various duty cycles, wherein each frequency interval corresponds to a representative frequency;
Step 3: setting the duty cycle of the laser to be a second duty cycle and setting the frequency of the laser to be the representative frequency, adjusting the current so that the average output power of the laser is the minimum average power and the maximum average power, and recording the corresponding currents as the minimum current and the maximum current; and determining a current-average power relationship based on the minimum current, the maximum current, a peak power corresponding to the maximum current, a peak power corresponding to the minimum current, the second duty cycle, a peak power corresponding to the first level, a duration of the first level, and the representative frequency;
changing the duty cycle, and repeating Step 3 to obtain the current-average power relationship of the laser at various duty cycles and in different frequency intervals.

The laser power correction method for suppressing relaxation oscillations provided in the embodiments of the present disclosure is applicable to a pulsed laser control method that adds a small step signal for suppressing relaxation oscillation. It not only refers to the current-power curve of the laser manufacturer, but also determines the actual current-average power relationship by actually measuring the power output value of the laser, thereby achieving accurate correction/calibration of the laser.

Optionally, the current-average power relationship is as follows:

$$I_{out}= [ (P_{out} - P_{p\_It0} * t_0 * f - P_{Ith}*D )/(P_{pmax} *D - P_{Ith}*D) ](I_{max}-I_{th})+ I_{th}$$

wherein, $I_{out}$ is current, $P_{out}$ is average output power of the laser, $P_{p\_It0}$ is peak power of the first level, $t_0$ is duration of the first level, f is representative frequency, $P_{Ith}*D$ is minimum average power, $P_{pmax} *D$ is maximum average power, $P_{pmax}$ is peak power corresponding to the maximum current, $P_{Ith}$ is peak power corresponding to the minimum current, D is duty cycle, $I_{max}$ is maximum current, and $I_{th}$ is minimum current.

The embodiments of the present disclosure provide a calculation formula for the current-average power relationship, which can achieve accurate correction of the laser.

Optionally, the preset power is the minimum average power or the maximum average power of the laser; or the preset power is a power within a tolerance of the minimum average power or the maximum average power of the laser.

In the embodiments of the present disclosure, the relationship between current and average power is determined based on the minimum average power, the maximum average power and their corresponding minimum current and maximum current, thereby achieving accurate correction of the laser.

Optionally, the median of the frequency interval is set to be the corresponding representative frequency.

In the embodiments of the present disclosure, the frequencies involved in the laser are segmented, thereby simplifying the workload of power correction.

Optionally, it further comprises: determining a single pulse energy of the first level.

The correction method in the embodiments of the present disclosure further includes calculating the single pulse energy of the small step signal that suppresses relaxation oscillation, thereby determining the magnitude of the pulse energy of the small step signal and its impact on the normal output of the laser.

Optionally, the single pulse energy is calculated as follows:

$$E= P_{a\_It0}/f$$

where E is single pulse energy, $P_{a\_It0}$ is average power of the first level, and f is frequency.

Optionally, the single pulse energy is calculated as follows:

$$E= P_{a\_It0} * t_0$$

wherein E is single pulse energy, $P_{a\_It0}$ is average power of the first level, and $t_0$ is duration of the first level.

The embodiments of the present disclosure provide a specific calculation method for the pulse energy of the small step signal, thereby determining the pulse energy of the small step signal and its influence on the normal output of the laser.

The embodiments of the present disclosure provide a laser power correction device for suppressing relaxation oscillation, comprising:

a frequency segmentation module configured to perform the following steps:

Step 1: setting a duty cycle of a laser to a first duty cycle and setting a frequency of the laser to a first frequency, adjusting current so that an average output power of the laser is a preset power, and recording the present current value, wherein a waveform of the current comprises a first level and a second level, the amplitude of the first level is smaller than the amplitude of the second level, and the amplitude of a laser relaxation oscillation waveform induced by a current signal of first level is smaller than a safety threshold;

Step 2: adjusting the frequency based on the present current value and the first duty cycle so that the average output power of the laser is the preset power, and recording all frequency values to obtain a frequency interval; changing the duty cycle, repeating Steps 1 and 2, to obtain frequency intervals of the laser at various duty cycles, wherein each frequency interval corresponds to a representative frequency;

a power correction module configured to perform the following steps:

Step 3: setting the duty cycle of the laser to a second duty cycle and setting the frequency of the laser to the representative frequency, adjusting the current so that the average output power of the laser is the minimum average power and the maximum average power, and recording the corresponding currents as the minimum current and the maximum current; and determining a current-average power relationship based on the minimum current, the maximum current, a peak power corresponding to the maximum current, a peak power corresponding to the minimum current, the second duty cycle, a peak power corresponding to the first level, a duration of the first level, and the representative frequency; changing the duty cycle, and repeating Step 3 to obtain the current-average power relationship of the laser at various duty cycles and in different frequency intervals.

Optionally, the current-average power relationship is as follows:

$$I_{out}= [\ (P_{out} - P_{p\_lt0} *t_0 * f - P_{Ith}*D\ )/(P_{pmax} *D - P_{Ith}*D)\ ](I_{max}-I_{th})+ I_{th}$$

wherein, $I_{out}$ is current, $P_{out}$ is average output power of the laser, $P_{p\_lt0}$ is peak power of the first level, $t_0$ is duration of the first level, f is representative frequency, $P_{Ith}*D$ is minimum average power, $P_{pmax} *D$ is maximum average power, $P_{pmax}$ is peak power corresponding to the maximum current, $P_{Ith}$ is peak power corresponding to the minimum current, D is duty cycle, $I_{max}$ is maximum current, and $I_{th}$ is minimum current.

The embodiments of the present disclosure provide a laser, comprising a computer-readable storage medium storing a computer program and a processor, wherein the laser power correction method for suppressing relaxation oscillation according to the above embodiments is implemented when the computer program is read and executed by the processor.

The laser power correction device and laser for suppressing relaxation oscillation provided in the embodiments of the present disclosure can achieve the same technical effect as the above-mentioned laser power correction method for suppressing relaxation oscillation.

## BRIEF DESCRIPTION OF THE DRAWINGS

In order to more clearly illustrate the embodiments of the present disclosure or the technical solutions in the prior art, the following briefly introduces the drawings required for the description of the embodiments or the prior art. Obviously, the drawings described below are merely part of the embodiments of the present disclosure. For ordinary technicians in this field, other drawings can be obtained based on the provided drawings without paying any creative work.

FIG. 1 is a curve of the driving current and the laser output power of a laser diode provided by an embodiment of the present disclosure;

FIG. 2 is a schematic flow chart of a laser power correction method for suppressing relaxation oscillation provided by an embodiment of the present disclosure;

FIG. 3 is a schematic structural diagram of a laser power correction device for suppressing relaxation oscillation provided by an embodiment of the present disclosure.

## DETAILED DESCRIPTION OF EMBODIMENTS

In order to make the above-mentioned objects, features and advantages of the present disclosure more clearly understood, the following detailed description of the specific embodiments of the present disclosure is given in conjunction with the accompanying drawings. It should be understood that the specific embodiments described herein are only used to explain the present disclosure and are not intended to limit the present disclosure.

The parameters involved in the embodiments of the present disclosure are as follows: average power ($P_a$), peak power ($P_p$), pulse energy ($E_p$), pulse output frequency (f), duty cycle (D), and peak pulse duration (t).

Patent CN202410703660X describes a laser current control method for suppressing laser relaxation oscillation. A small step current waveform is designed to suppress relaxation oscillation. The current control algorithm formula for suppressing relaxation oscillations is as follows:

$$P_{out}= P_{p\_lt0} * \ (t_0 * f)\ + [(I_{out} - I_{th}\ )/(I_{max}-I_{th})] * (P_{pmax} *D)$$

Wherein, $P_{out}$ is the average output power of the laser, $P_{p\_lt0}$ is the peak power corresponding to the first level, $t_0$ is the duration of the first level, f is the representative frequency, $I_{out}$ is the drive current, $I_{max}$ is the maximum drive current, $I_{th}$ is the threshold current, $P_{pmax}$ is the laser peak power corresponding to the maximum drive current, and D is the duty cycle corresponding to the second level.

A prerequisite for the above derived formula, as described in the patent description, is that the value of $I_{th}$ is selected just when the laser diode (LD) is emitting light, at which point the average power is essentially negligible. In actual laser medical device products, selecting the threshold current $I_{th}$ when the laser LD just emits light is often only determined by consulting the LD manufacturer's specifications, making practical application difficult. For example, using a laser power meter to measure the average output power of the laser, when driving the LD at the threshold current $I_{th}$, is inherently weak, making it difficult to measure, and consequently, determine the appropriate $I_{th}$ value.

In order to solve the difficulties in the above description, the above control algorithm is expanded, and the minimum average output power of a product is selected as the average power PaIth corresponding to Ith. At this time, the peak power corresponding to Ith is Pth.

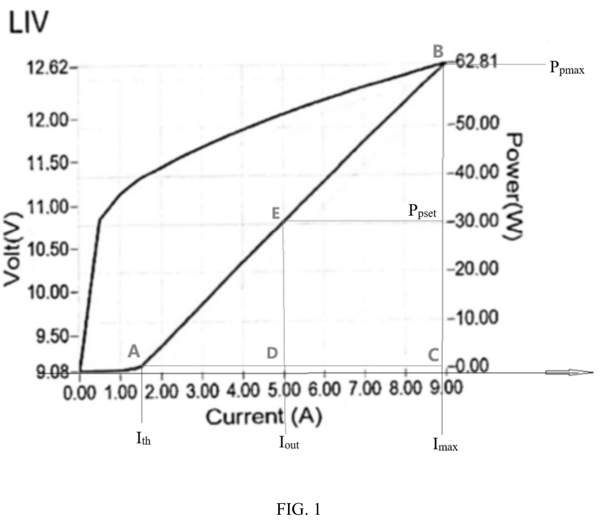

FIG. 1 shows curves of drive current and laser output power of a laser diode. The lower side of FIG. 1 shows the current- laser peak power curve, and the upper side shows the current-voltage curve. In FIG. 1, the current at point A is Ith, and the corresponding peak power is PIth; the current at point E is Iout, and the corresponding peak power is Ppset; the current at point B is Imax, and the corresponding peak power is Ppmax.

In the embodiments of the present disclosure, it further expands the algorithm in the existing patent CN202410703660X according to FIG. 1 to obtain formula ①:

$$I_{out}= [\ (P_{out} - P_{p\_It0}*t_0*f - P_{Ith}*D\ )/(P_{pmax}*D - P_{Ith}*D)\ ](I_{max}-I_{th})+ I_{th} \quad ①$$

Where, $I_{out}$ is the current, $P_{out}$ is the average output power of laser, $P_{p\_It0}$ is the peak power of the first level, $t_0$ is the duration of the first level, f is the representative frequency, $P_{Ith}*D$ is the minimum average power, $P_{pmax}*D$ is the maximum average power, $P_{pmax}$ is the peak power corresponding to the maximum current, $P_{Ith}$ is the peak power corresponding to the minimum current, D is the duty cycle, $I_{max}$ is the maximum current, and $I_{th}$ is the minimum current.

Based on FIG. 1, formula ① is derived as follows:

$$\because BC \perp AC,\ ED \perp AC,$$

$$\therefore ED \ /\!/ \ BC$$

$$\text{Again,}\ \angle EAD = \angle BAC$$

$$\angle AED = \angle ABC$$

$$\angle ADE = \angle ACB$$

$$\therefore \ \triangle EAD \backsim \triangle BAC$$

$$\therefore \ ED : BC = AD : AC$$

$$\therefore \qquad (P_{pset} - P_{Ith}) \ : \ (P_{pmax} - P_{Ith}) \ = \ (I_{out}-I_{th}) \ : \ (I_{max}-I_{th})$$

$$\therefore \ I_{out} \ = \ (P_{pset} - P_{Ith})\,(I_{max}-I_{th})/(P_{pmax} - P_{Ith})+ I_{th} \quad \text{Formula 1}$$

Therefore, when implementing power correction, it is only necessary to find $I_{max}$ and $I_{th}$ corresponding to each frequency segment, as well as $P_{pmax}$, and then you can calculate the required current based on the $P_{pset}$ set on the screen; the formula relationship between the peak power $P_{Ith}$ and the average power $P_{alth}$ at this time is as follows:

$$P_{Ith} = P_{alth}/D \quad \text{Formula 2}$$

D is the duty cycle, $P_{alth}$ is the average power, $P_{Ith}$ is peak power corresponding to $I_{th}$ at duty cycle D.

According to the current-peak power curve derived from the above formula, if $I_{th}$=1.5A is selected, the corresponding $P_{Ith}$ is equal to 0, at this time the effect of $P_{Ith}$ in the above formula 1 is negligible, which is equivalent to:

$$I_{out} = (\ P_{pset}\ )\,(I_{max} - I_{th}\ )/(\ P_{pmax}\ )+ I_{th}$$

According to actual needs, you can choose an appropriate peak power ( $I_{th}$, $P_{Ith}$ ) as a starting point.

The average output power $P_{out}$ of the laser is equal to the average power $P_{t0}$ of the small step plus the average power $P_{set}$ of the current curve output, so:

$$P_{out} = P_{t0} + P_{Iout} \quad \text{Formula 3}$$

Since the average power $P_{Iout}$ that needs to be output is equal to the peak power $P_{pset}$ corresponding to $I_{out}$ multiplied by the duty cycle D, that is, by adjusting the current corresponding to the effective current time period t1, a laser peak power $P_{pset}$ can be obtained. The peak power multiplied by the duty cycle equals the average power $P_{Iout}$ at this time, so:

$$P_{Iout} = P_{pset} * D \qquad \text{Formula 4}$$

Furthermore, $\because$ formulas 1, 2, and 4,

$$\therefore \qquad I_{out} = [(P_{Iout} - P_{alth})/(P_{pmax} * D - P_{alth})] * (I_{max} - I_{th}) + I_{th} \qquad \text{Formula 5}$$

Based on the similar triangles, $I_{th}$ can be taken as the value when the laser just starts to emit light and the laser is just about to be emitted (the laser peak power at this time is close to 0W). This value is fixed according to the laser pump source model. You can also take a larger $I_{th}$ according to the average power range of the laser to obtain a suitable $(I_{th}, P_{Ith})$. For example, if the average power range of the laser is 0.5W~20W, then take $P_{alth} = 0.5W$, then through $P_{Ith} = P_{alth}/D$, you can calculate the peak power $P_{Ith}$. But according to Formula 4 derived from Formula 1, Formula 4 now becomes:

$$I_{out} = [ (P_{Iout} - 0.5 )/(P_{pmax} * D - 0.5) ] * (I_{max} - I_{th}) + I_{th}$$

Since the maximum output current $I_{max}$ definitely corresponds to the maximum laser peak power $P_{pmax}$, $P_{pmax}$ and $I_{max}$ are fixed known values. Since the duty cycle of the output current waveform is known, the current $I_{out}$ that the MCU needs to output can be calculated according to the average power $P_{Iout}$ that needs to be output.

According to Formula 3, there's an average power of a small step, $P_{t0}$, between the laser power output by the laser terminal device and the average power output by the current regulation. Because the current value and duration, $t_0$, of this small step, which are damaged by suppressing relaxation oscillation, are fixed through circuit tuning (the principle is to adjust the output current and $t_0$ to ensure the laser waveform of relaxation oscillation do not exceed the tolerances of the optical components in the optical path), $P_{t0}$ is a constant. Therefore, once $P_{t0}$ is calculated, the relationship between the regulated output current $I_{out}$ and the average power $P_{out}$ output by the laser terminal device can be derived as follows:

$$I_{out} = ( ( (P_{out} - P_{t0}) - P_{alth} )/(P_{pmax} * D - P_{alth}) ) (I_{max} - I_{th}) + I_{th} \qquad \text{Formula 6}$$

The calculation method of the average power corresponding to the small step at "$t_0$" time is as follows.

The average power $P_{t0\_cw}$ of the continuous mode corresponding to $I_{t0}$ is:

$$P_{t0\_cw} = P_{p\_It0}$$

Since the width of the small step is $t_0$, we can assume that $t_0$ is also a pulse waveform output at a frequency f under a certain duty cycle. Its duty cycle is:

$$D_{t0} = t_0 /T = t_0 * f$$

Because the average power of the laser output in PWM mode is equal to the peak power multiplied by the duty cycle, the average power of the small step is:

$$P_{t0} = P_{p\_It0} * D_{t0} = P_{p\_It0} * (t_0 * f)$$

Because $P_{p\_It0}$ can be obtained based on $I_{t0}$, and $t_0$ is known by debugging and is a constant, $P_{t0}$ is also a constant.

So Formula 6 can be transformed into the following form:

$$I_{out} = [ ( P_{out} - P_{p\_It0} * t_0 * f - P_{Ith} * D)/(P_{pmax} * D - P_{Ith} * D) ] * (I_{max} - I_{th}) + I_{th}$$

Based on this formula, an embodiment of the present disclosure designs a power correction method that can be better applied to laser medical products.

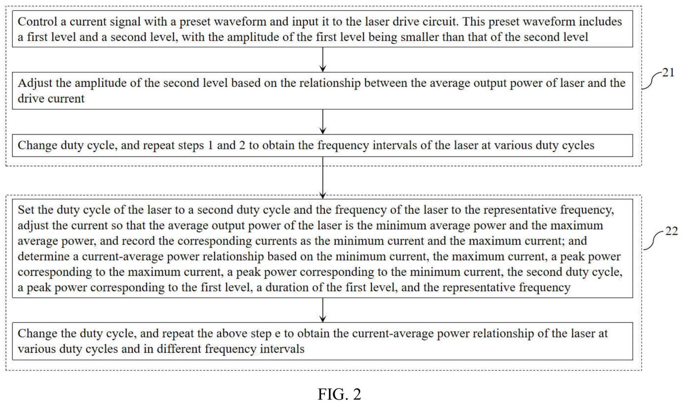

FIG.2 shows a schematic flow chart of a laser power correction method for suppressing relaxation oscillation provided by an embodiment of the present disclosure. The method includes a frequency segmentation process S21 and a power correction process S22.

The above frequency segmentation process can segment the frequencies involved in the laser and simplify the power correction workload. It specifically includes the following steps:

Step 1: Set the duty cycle of the laser to a first duty cycle and set the frequency of the laser to a first frequency, adjust the current so that the average power output by the laser (the average output power of the laser) is a preset power, and record the present current value.

As described in the above method of suppressing relaxation oscillation, the current waveform includes a first level and a second level, with the amplitude of the first level being smaller than the amplitude of the second level. The amplitude of the laser relaxation oscillation waveform induced by the first level current signal is smaller than a safety threshold. This safety threshold is affected by the parameters of the components in the laser drive circuit, and relaxation oscillation with amplitudes below this safety threshold will not damage components in the optical path.

Because higher drive currents increase the peak power generated by the laser diode, the resulting relaxation oscillation waveform in the early stages of laser balance establishment becomes higher. When this value exceeds a certain value, it can damage optical components. Therefore, this embodiment first uses a smaller first level current to allow the laser to establish laser balance before outputting the high current corresponding to the effective PWM (Pulse Width Modulation) signal. In this way, because laser balance has already been largely established by the time the high current is output to the laser diode, subsequent high-current driving of the laser diode will not induce large relaxation oscillation waveforms. The amplitude of the relaxation oscillation waveform induced by the initial small step current is relatively small, within the acceptable range of the optical components in the optical path, thereby successfully suppressing damage to the optical components in the optical path caused by relaxation oscillations.

Optionally, the preset power may be the minimum average power or the maximum average power of the laser; or the preset power may be a power within a tolerance of the minimum average power or the maximum average power of the laser. For example, the tolerance is 20%.

In this embodiment, the operation is first performed at a certain duty cycle and frequency, and the average power output is detected while adjusting the current to obtain the current corresponding to the preset power under this condition.

Current regulations for laser medical devices require that the output power of the laser terminal be within $\pm$20% of the power stated in the product's technical requirements. For example, the product's power range is 0.5W to 20W, and the frequency adjustment range is 1Hz to 250Hz. As described in the prior patent, the relationship between $I_{th}$ and the drive frequency is $I_{th} = Af + B$. However, to meet the tolerances required by national testing requirements, the laser output frequency can be set to f, and the duty cycle is taken as D = 5%. The output current can be adjusted to ensure that the average power measured by the power meter is within the range of 0.5W $\pm$ 20%. The current at this point is recorded as $I_{th}$.

Step 2: Using the present current value and the first duty cycle, adjust the frequency so that the average output power of the laser is the preset power, and record all frequency values to obtain a frequency interval.

In this embodiment, the operation is further performed at a certain duty cycle and current, and the average output power is detected while adjusting the frequency to obtain all frequency values that can output the above-mentioned preset frequency. The above-mentioned frequency values constitute a frequency interval.

At this point, fix the output $I_{th}$, and D at 5%, we begin modifying f, we can statistically determine that within certain continuous frequency intervals (for example, 0Hz-150Hz and 151Hz-250Hz), the same $I_{th}$ can achieve an effect of 0.5W $\pm$ 20%. We then place these frequency intervals within the aforementioned 5% duty cycle range. For example, for a 5% duty cycle pulse width, we set two frequency segments: 0Hz-150Hz and 151Hz-250Hz.

By changing the duty cycle and repeating Steps 1 and 2, the frequency interval of the laser at each duty cycle is obtained. Each frequency interval corresponds to a representative frequency.

By repeating Steps 1 and 2, the frequency segmentation of the laser at all duty cycles can be obtained. This is based on the following logic: since $I_{th}$ is under a fixed duty cycle D, in a certain frequency interval, the average output power is within 0.5W$\pm$20%, so the middle frequency of this frequency interval is taken, marked as $f_{re}$. According to the relationship $I_{th} = Af + B$, it can be seen that this $f_{re}$ can represent all frequencies in the frequency interval, to participate in the calculation of current output. For example, the median value of the above frequency interval can be set as the corresponding representative frequency.

Based on the segmentation/division of the above frequency intervals, even if there are many frequencies, power correction can be performed quickly within the tolerance.

In the above power correction process, the formula can be formulated by selecting the maximum and minimum points of the "current-power curve". Specifically, it includes the following steps:

Step 3: Set the laser's duty cycle to the second duty cycle and set the frequency to the representative frequency. Adjust the current so that the average output power of the laser is the minimum average power and the maximum average power, and record the corresponding currents as the minimum current and the maximum current. Furthermore, determine the current-average power relationship based on the minimum current, the maximum current, the peak power corresponding to the maximum current, the peak power corresponding to the minimum current, the second duty cycle, the peak power corresponding to the first step, the duration of the first step, and the representative frequency.

Optionally, in this embodiment, the current-average power relationship is as follows:

$$I_{out}= [ (P_{out} - P_{p\_lt0} *t_0 * f- P_{lth}*D )/(P_{pmax} *D - P_{Ith}*D) ](I_{max}-I_{th})+ I_{th}$$

Where, $I_{out}$ is the current, $P_{out}$ is the average output power of the laser, $P_{p\_lt0}$ is the peak power of the first level, $t_0$ is the duration of the first level, f is the representative frequency, $P_{lth} * D$ is the minimum average power, $P_{pmax}*D$ is the maximum average power, $P_{pmax}$ is the peak power corresponding to the maximum current, $P_{lth}$ is the peak power corresponding to the minimum current, D is the duty cycle, $I_{max}$ is the maximum current, and $I_{th}$ is the minimum current.

In this embodiment, the duty cycle is fixed as $D = D_{sp}$, and the frequency is the representative frequency $f_{re}$ in the aforementioned frequency interval. At this time, the output current is adjusted so that the average output power of the laser reaches the minimum power (for example, the aforementioned minimum average output power is 0.5W). The current at this time is recorded as the minimum current $I_{th}$ in the frequency interval. The output current is then further adjusted so that the average output power of the laser reaches the maximum average power (for example, the aforementioned maximum average output power is 20W). The maximum current $I_{max}$ at this time is recorded.

Based on that the average power is equal to peak power multiplied by duty cycle, $P_{lth}*D$ and $P_{pmax} *D$ in formula ① are already determined (both the minimum peak power $P_{lth}$ and the maximum peak power $P_{pmax}$ can also be determined). Continuing with the previous example, let's assume they are 0.5W and 20W, respectively. Taking $f_{re}$ as f, we obtain the linear equation relationship between $P_{out}$ and $I_{out}$. The user can set different average powers $P_{out}$ on the screen to calculate the required output current.

Based on the above relationship among average power, peak power and duty cycle, the average output power range of various products can be flexibly adapted, which also reflects the advantages of the embodiments of the present disclosure.

Change the duty cycle and repeat the above Step 3 to obtain the current-average power relationship of the laser at various duty cycles and in different frequency intervals.

Continuing with the previous example, modify the duty cycles to $D = D_{mp} = 10\%$ and $D = D_{lp} = 20\%$, respectively. Repeat Step 3 to obtain the linear equation relationship of "current-average power" in different frequency intervals at each duty cycle.

Based on the above power correction method, the data shown in Table 1 are obtained.

Table 1

| Laser LD model | | | | | | |
|---|---|---|---|---|---|---|
| Pulse Width | | Segment | Frequency interval | Average power (W) | Current (mA) | Frequency used during correction (Hz) |
| SP(D=5%) | | Band1 | 0-150 | 0.5 | 1000 | 75 |
| | | | | 5 | 9200 | 75 |
| | | Band2 | 151-250 | 0.5 | 1965 | 200 |
| | | | | 5 | 8800 | 200 |
| | | Band3 | 0 | | | |
| | | | | | | |
| | | Band4 | 0 | | | |
| | | | | | | |
| | | Band5 | 0 | | | |
| | | | | | | |
| MP(O=10%) | | Band1 | 0-150 | 0.5 | 1880 | 75 |
| | | | | 10 | 9100 | 75 |
| | | Band2 | 151-250 | 0.5 | 1780 | 200 |
| | | | | 10 | 8900 | 200 |
| | | Band3 | 0 | | | |
| | | | | | | |

(continued)

| Laser LD model | | | | | |
|---|---|---|---|---|---|
| Pulse Width | Segment | Frequency interval | Average power (W) | Current (mA) | Frequency used during correction (Hz) |
| | Band4 | 0 | | | |
| | | | | | |
| | Band5 | 0 | | | |
| | | | | | |
| LP(D=20%) | Band1 | 0-150 | 0.5 | 1710 | 75 |
| | | | 20 | 6800 | 75 |
| | Band2 | 151-250 | 0.5 | 1620 | 200 |
| | | | 20 | 6700 | 200 |
| | Band3 | 0 | | | |
| | | | | | |
| | Band4 | 0 | | | |
| | | | | | |
| | Band5 | 0 | | | |
| | | | | | |
| Coupling efficiency K | Coupler transmission efficiency | | Transmission efficiency | | |
| | 100% | | 100% | | |
| Relaxation oscillation step single pulse energy E ( mJ ) | 1 | | | | |

Table 1 shows three duty cycles: $D_{sp} = 5\%$, $D_{mp} = 10\%$, and $D_{lp} = 20\%$, with frequency intervals of 0 Hz to 150 Hz (representative frequency is 75 Hz) and 151 Hz to 250 Hz (representative frequency is 200 Hz), and average output power ranges of 0.5 W to 5 W, 0.5 W to 10 W, and 0.5 W to 20 W. The corresponding current values were measured. Furthermore, the relationship between current and average power in different frequency intervals for each duty cycle can be derived based on the above formula ①.

The laser power correction method for suppressing relaxation oscillations provided in the embodiments of the present disclosure is applicable to a pulsed laser control method that adds a small step signal for suppressing relaxation oscillation. It not only refers to the current-power curve of the laser manufacturer, but also determines the actual current-average power relationship by actually measuring the power output value of the laser, thereby achieving accurate correction of the laser.

Furthermore, an embodiment of the present disclosure also provides the above-mentioned step single pulse energy for suppressing the relaxation oscillation phenomenon.

First, set the current and duration $t_0$ required for the small step for suppressing relaxation oscillation phenomenon, set the small step optical signal to output at 100 Hz or above (The frequency depends primarily on the range and scale of the power meter used during testing. If the power meter is very sensitive, choose a smaller output frequency; if it is not very sensitive, choose a higher output frequency so that the power meter can measure and identify it). Then, based on the principle that average power equals pulse energy multiplied by frequency, divide the average power obtained by the power meter by the output frequency at that time to obtain the "step single pulse energy for suppressing the relaxation oscillation phenomenon" E required for the small step for suppressing relaxation oscillation. This is recorded in the last row of Table 1.

Alternatively, the single pulse energy is calculated as follows: $E = Pa_{lt0}/f$ or $E = P_{a\_lt0} * t_0$

Where E is the single pulse energy, $P_{a\_lt0}$ is the average power of the first level, f is the frequency, and $t_0$ is the duration of the first level.

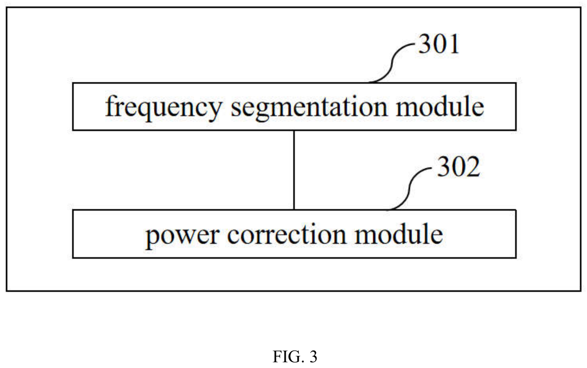

FIG. 3 shows a schematic structural diagram of a laser power correction device for suppressing relaxation oscillation according to an embodiment of the present disclosure. The device includes:

a frequency segmentation module 301 configured to perform the following steps:

> Step 1: setting a duty cycle of a laser to a first duty cycle and setting a frequency of the laser to a first frequency, adjusting current so that an average output power of the laser is a preset power, and recording the present current value, wherein a waveform of the current comprises a first level and a second level, the amplitude of the first level is smaller than the amplitude of the second level, and the amplitude of a laser relaxation oscillation waveform induced by a current signal of first level is smaller than a safety threshold;
> Step 2: adjusting the frequency based on the present current value and the first duty cycle so that the average output power of the laser is the preset power, and recording all frequency values to obtain a frequency interval;

changing the duty cycle, repeating Steps 1 and 2, to obtain frequency intervals of the laser at various duty cycles, wherein each frequency interval corresponds to a representative frequency;
a power correction module 302 configured to perform the following steps:
Step 3: setting the duty cycle of the laser to a second duty cycle and setting the frequency of the laser to the representative frequency, adjusting the current so that the average output power of the laser is the minimum average power and the maximum average power, and recording the corresponding currents as the minimum current and the maximum current; and determining a current-average power relationship based on the minimum current, the maximum current, a peak power corresponding to the maximum current, a peak power corresponding to the minimum current, the second duty cycle, a peak power corresponding to the first level, a duration of the first level, and the representative frequency;
changing the duty cycle, and repeating Step 3 to obtain the current-average power relationship of the laser at various duty cycles and in different frequency intervals.

Optionally, the current-average power relationship is as follows:

$$I_{out} = [\ (P_{out} - P_{p\_lt0} * t_0 * f - P_{lth} * D\ )/(P_{pmax} * D - P_{lth} * D)\ ](I_{max} - I_{th}) + I_{th}$$

wherein, $I_{out}$ is current, $P_{out}$ is average output power of the laser, $P_{p\_lt0}$ is peak power of the first level, $t_0$ is duration of the first level, f is representative frequency, $P_{lth} * D$ is minimum average power, $P_{pmax} * D$ is maximum average power, $P_{pmax}$ is peak power corresponding to the maximum current, $P_{lth}$ is peak power corresponding to the minimum current, D is duty cycle, $I_{max}$ is maximum current, and $I_{th}$ is minimum current.

The embodiments of the present disclosure provide a laser, comprising a computer-readable storage medium storing a computer program and a processor, wherein the laser power correction method for suppressing relaxation oscillation is implemented when the computer program is read and executed by the processor.

The laser power correction device and laser for suppressing relaxation oscillation provided in the embodiments of the present disclosure can achieve the same technical effects as the laser power correction method for suppressing relaxation oscillation provided in the above embodiments. To avoid repetition, they will not be described here.

Although the present disclosure is described as above, the present disclosure is not limited thereto. Any person skilled in the art can make various changes and modifications without departing from the spirit and scope of the present disclosure. Therefore, the scope of protection of the present disclosure should be based on the scope defined by the claims.

Finally, it should be noted that, in this document, relational terms such as first and second, etc., are used only to distinguish one entity or operation from another entity or operation, and do not necessarily require or imply any actual relationship or order between these entities or operations. Moreover, the terms "comprise", "include" or any other variations thereof are intended to cover non-exclusive inclusion, such that a process, method, article, or device comprising a series of elements includes not only those elements, but also other elements not explicitly listed, or elements inherent to such process, method, article, or device. In the absence of further limitations, an element defined by the phrase "comprising a..." does not exclude the presence of additional identical elements in the process, method, article, or device comprising the element.

The above description of the disclosed embodiments is intended to enable one skilled in the art to implement or use the present disclosure. Various modifications to these embodiments will be readily apparent to one skilled in the art, and the general principles defined herein may be implemented in other embodiments without departing from the spirit or scope of the present disclosure. Therefore, the present disclosure is not limited to the embodiments shown herein but is intended to conform to the widest scope consistent with the principles and novel features disclosed herein.

**Claims**

1. A laser power correction method for suppressing relaxation oscillation, comprising:

Step 1: setting a duty cycle of a laser to be a first duty cycle and setting a frequency of the laser to be a first frequency, adjusting current so that an average output power of the laser is a preset power, and recording the present current value, wherein a waveform of the current comprises a first level and a second level, the amplitude of the first level is smaller than the amplitude of the second level, and the amplitude of a laser relaxation oscillation waveform induced by a current signal of first level is smaller than a safety threshold; wherein the laser comprises a laser diode;

Step 2: adjusting the frequency based on the present current value and the first duty cycle so that the average output power of the laser is the preset power, and recording all frequency values to obtain a frequency interval; changing the duty cycle, repeating Steps 1 and 2, to obtain frequency intervals of the laser at various duty cycles, wherein each frequency interval corresponds to a representative frequency;

Step 3: setting the duty cycle of the laser to be a second duty cycle and setting the frequency of the laser to be the representative frequency, adjusting the current so that the average output power of the laser is the minimum average power and the maximum average power, and recording the corresponding currents as the minimum current and the maximum current; and determining a current-average power relationship based on the minimum current, the maximum current, a peak power corresponding to the maximum current, a peak power corresponding to the minimum current, the second duty cycle, a peak power corresponding to the first level, a duration of the first level, and the representative frequency;

changing the duty cycle, and repeating Step 3 to obtain the current-average power relationship of the laser at various duty cycles and in different frequency intervals.

2. The method according to claim 1, wherein the current-average power relationship is as follows:

$$I_{out}= [ (P_{out} - P_{p\_It0} *t_0 * f - P_{Ith}*D )/(P_{pmax} *D - P_{Ith}*D) ](I_{max}-I_{th})+ I_{th}$$

wherein, $I_{out}$ is current, $P_{out}$ is average output power of the laser, $P_{p\_It0}$ is peak power of the first level, $t_0$ is duration of the first level, f is representative frequency, $P_{Ith}*D$ is minimum average power, $P_{pmax} *D$ is maximum average power, $P_{pmax}$ is peak power corresponding to the maximum current, $P_{Ith}$ is peak power corresponding to the minimum current, D is duty cycle, $I_{max}$ is maximum current, and $I_{th}$ is minimum current.

3. The method according to claim 1, wherein the preset power is the minimum average power or the maximum average power of the laser; or

the preset power is a power within a tolerance of the minimum average power or the maximum average power of the laser.

4. The method according to claim 1, wherein the median of the frequency interval is set to be the corresponding representative frequency.

5. The method according to claim 1, further comprising: determining a single pulse energy of the first level.

6. The method according to claim 5, wherein the single pulse energy is calculated as follows:

$$E= P_{a\_It0}/f$$

where E is single pulse energy, $P_{a\_It0}$ is average power of the first level, and f is frequency.

7. The method according to claim 5, wherein the single pulse energy is calculated as follows:

$$E= P_{a\_It0} * t_0$$

wherein E is single pulse energy, $P_{a\_It0}$ is average power of the first level, and $t_0$ is duration of the first level.

8. A laser power correction device for suppressing relaxation oscillation, comprising:

   a frequency segmentation module configured to perform the following steps:

   Step 1: setting a duty cycle of a laser to be a first duty cycle and setting a frequency of the laser to be a first frequency, adjusting current so that an average output power of the laser is a preset power, and recording the present current value, wherein a waveform of the current comprises a first level and a second level, the amplitude of the first level is smaller than the amplitude of the second level, and the amplitude of a laser relaxation oscillation waveform induced by a current signal of first level is smaller than a safety threshold; wherein the laser comprises a laser diode;
   Step 2: adjusting the frequency based on the present current value and the first duty cycle so that the average output power of the laser is the preset power, and recording all frequency values to obtain a frequency interval;

   changing the duty cycle, repeating Steps 1 and 2, to obtain frequency intervals of the laser at various duty cycles, wherein each frequency interval corresponds to a representative frequency;
   a power correction module configured to perform the following steps:
   Step 3: setting the duty cycle of the laser to be a second duty cycle and setting the frequency of the laser to be the representative frequency, adjusting the current so that the average output power of the laser is the minimum average power and the maximum average power, and recording the corresponding currents as the minimum current and the maximum current; and determining a current-average power relationship based on the minimum current, the maximum current, a peak power corresponding to the maximum current, a peak power corresponding to the minimum current, the second duty cycle, a peak power corresponding to the first level, a duration of the first level, and the representative frequency;
   changing the duty cycle, and repeating Step 3 to obtain the current-average power relationship of the laser at various duty cycles and in different frequency intervals.

9. The device according to claim 8, wherein the current-average power relationship is as follows:

$$I_{out} = [ (P_{out} - P_{p\_It0} * t_0 * f - P_{Ith} * D )/(P_{pmax} * D - P_{Ith} * D) ](I_{max} - I_{th}) + I_{th}$$

   wherein, $I_{out}$ is current, $P_{out}$ is average output power of the laser, $P_{p\_It0}$ is peak power of the first level, $t_0$ is duration of the first level, f is representative frequency, $P_{Ith} * D$ is minimum average power, $P_{pmax} * D$ is maximum average power, $P_{pmax}$ is peak power corresponding to the maximum current, $P_{Ith}$ is peak power corresponding to the minimum current, D is duty cycle, $I_{max}$ is maximum current, and $I_{th}$ is minimum current.

10. A laser, comprising a computer-readable storage medium storing a computer program and a processor, wherein the laser power correction method for suppressing relaxation oscillation according to any one of claims 1 to 7 is implemented when the computer program is read and executed by the processor.

FIG. 1

Control a current signal with a preset waveform and input it to the laser drive circuit. This preset waveform includes a first level and a second level, with the amplitude of the first level being smaller than that of the second level

Adjust the amplitude of the second level based on the relationship between the average output power of laser and the drive current

Change duty cycle, and repeat steps 1 and 2 to obtain the frequency intervals of the laser at various duty cycles

21

Set the duty cycle of the laser to a second duty cycle and the frequency of the laser to the representative frequency, adjust the current so that the average output power of the laser is the minimum average power and the maximum average power, and record the corresponding currents as the minimum current and the maximum current; and determine a current-average power relationship based on the minimum current, the maximum current, a peak power corresponding to the maximum current, a peak power corresponding to the minimum current, the second duty cycle, a peak power corresponding to the first level, a duration of the first level, and the representative frequency

Change the duty cycle, and repeat the above step e to obtain the current-average power relationship of the laser at various duty cycles and in different frequency intervals

22

FIG. 2

FIG. 3

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202410703660X